# EUROPEAN PATENT APPLICATION

(11) **EP 2 894 658 A1**
(43) Date of publication of application: **15.07.2015**
(21) Application number: 13834518.6
(22) Date of filing: 19.08.2013
(51) Int. Cl.: H01L 21/02

(54) **METHOD FOR FABRICATING MULTI-GROOVE STRUCTURE**

(30) Priority: 05.09.2012 CN 201210325243
(71) Applicant: CSMC Technologies Fab1 Co., Ltd., Wuxi, Jiangsu 214028 (CN)
(72) Inventor: ZHANG, Xinwei, Wuxi Jiangsu 214028 (CN); DAI, Dan, Wuxi Jiangsu 214028 (CN); ZHOU, Guoping, Wuxi Jiangsu 214028 (CN); XIA, Changfeng, Wuxi Jiangsu 214028 (CN)
(74) Representative: Dietz, Christopher Friedrich
(86) International application number: PCT/CN2013/081793
(87) International publication number: WO 2014/036884

(57) **Abstract**

Provided is a method for fabricating a multi-trench structure, including steps of: performing anisotropic etching on a semiconductor substrate so as to form a vertical trench (100); growing a first epitaxial layer (110) on the semiconductor substrate in which the vertical trench (100) has been formed, so that the first epitaxial layer (110) covers the top of the vertical trench (100) to form a closed structure; performing anisotropic and isotropic etching on the closed structure, so as to form a trench array, and to make the trench array communicate with the vertical trench, the trench array including a number of trenches or vias, upper portions of a number of trenches or vias being separated from each other, and lower portions thereof communicating with each other to form a cavity (120); and growing a second epitaxial layer (130) to cover the trench array, so as to form a closed multi-trench structure. With two times of growth of the epitaxial layers, the multi-trench structure remains stable and solid in a fabricating process, which prevents phenomena of film breakage or falling off in the fabricating process.

## Description

### FIELD OF INVENTION

The present invention relates to a method for fabricating a semiconductor device structure, and more particularly to a method for fabricating a multi-trench structure in a semiconductor device, falling into the field of semiconductor device fabrication.

### BACKGROUND

Semiconductor devices include various electronic devices that exploit special electrical properties of semiconductor materials to fulfill particular functions. For particular functions of different devices, some devices demand fabrication of trench structures or cavity structures in various shapes in a semiconductor substrate to meet design requirements, especially in the case of Micro-Electro-Mechanical Systems (MEMS), where complex structured trenches and cavities, for example, a vertical deep trench with a higher aspect ratio, a trench array with the bottom portions communicating with each other to form a cavity and the top portions being separated from each other, or a multi-trench structure formed by various trenches and/or cavities communicating with each other, etc., need to be fabricated on the substrate to form the required micro mechanisms or devices.

However, in the fabrication of some multi-trench structures, for example, a multi-trench structure with a deep trench and a trench array communicating with each other, due to its relatively complex structure, high-speed drying is required after a conventional method has been used to continuously etch and directly interconnect trenches in different shapes, especially after a subsequent wet cleaning process has been finished, wherein the obtained trench sidewalls or other films surrounding the trenches very much incline to break or fall off, which may make it difficult to carry out the subsequent device fabrication process, and may even cause a large amount of wafers out of service, significantly increasing manufacturing costs.

In light of the foregoing, it is indeed essential to provide a fabrication process which enables a multi-trench structure to be more stable.

### SUMMARY OF THE INVENTION

The technical problem to be solved by the present invention is to provide a method for fabricating a multi-trench structure, which enables the formed multi-trench structure to be stable and solid, preventing phenomena of film breakage or falling off.

To solve the abovementioned technical problem, the prevent invention employs the following technical solutions:

A method for fabricating a multi-trench structure, comprising the following steps:
Step 1: performing anisotropic etching on a semiconductor substrate so as to form a vertical trench;
Step 2: growing a first epitaxial layer on the semiconductor substrate in which the vertical trench has been formed, so that the first epitaxial layer covers the top of the vertical trench to form a closed structure;
Step 3: performing anisotropic and isotropic etching on the closed structure, so as to form a trench array, and to make the trench array communicate with the vertical trench; the trench array comprising a plurality of trenches or vias, upper portions of the plurality of trenches or vias being separated from each other, and lower portions thereof communicating with each other to form a cavity;
Step 4: growing a second epitaxial layer to cover the trench array, so as to form a closed multi-trench structure.

As a preferred solution of the present invention, the semiconductor substrate is a silicon substrate.

As a preferred solution of the present invention, the first epitaxial layer is grown to 4∼10 µm in thickness.

As a preferred solution of the present invention, the first and second epitaxial layers are grown by reduced pressure chemical vapor deposition.

As a preferred solution of the present invention, the first and second epitaxial layers are grown at a set temperature of 1100°C∼1150°C.

As a preferred solution of the present invention, growth gas for growing the first and second epitaxial layers is SiH₂Cl₂, SiHCl₃ or SiCl₄.

As a preferred solution of the present invention, in Step 3, anisotropic etching is firstly performed on the closed structure to form a plurality of vias or trenches; and then, isotropic etching is performed on the plurality of vias or trenches, so that lower portions of adjacent vias or trenches to communicate with each other to form a cavity.

As a preferred solution of the present invention, the plurality of vias or trenches is arranged at a substantially equal interval.

As a preferred solution of the present invention, both the anisotropic etching and the isotropic etching are implemented by reactive ion etching.

The present invention achieves beneficial effects as follows:

The method for fabricating a multi-trench structure provided by the present invention combines anisotropic etching and isotropic etching processes, and by two times of growth of the epitaxial layers, enables the multi-trench structure to remain stable and solid in a fabricating process, preventing phenomena of film breakage or falling off in fabricating process.

### BRIEF DESCRIPTION OF THE DRAWINGS

Figs. 1a-1b illustrate a schematic cross section view of a structure obtained after completion of various steps of the prior method for fabricating a multi-trench structure.
Fig. 2 illustrates a flow chart of a method for fabricating a multi-trench structure according to an embodiment of the present invention.
Figs. 3a-3d illustrate a schematic cross section view of a structure obtained after completion of various steps of a method for fabricating a multi-trench structure according to an embodiment of the present invention.

### DETAILED DESCRIPTION

In the following discussions, technical solutions according to the embodiments of the present invention are to be described in a clear and complete manner in combination with the accompanying drawings, which are not drawn to scale for convenience of illustration. Apparently, the embodiments described herein constitute merely a portion of, instead of all, embodiments according to the present invention. Based on the embodiments of the present invention, all other embodiments acquired by those of ordinary skill in the art without creative efforts shall fall within the scope of protection of the present invention.

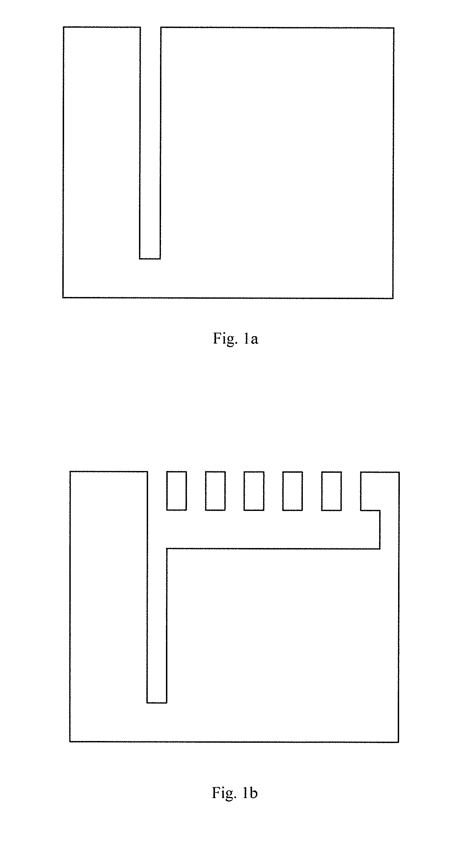

As mentioned in the Background part, in the fabrication of a semiconductor device, in order to form the required micro mechanisms and devices, a number of trenches need to be fabricated on a semiconductor substrate. In the traditional fabrication process, a required multi-trench structure is formed by continuously etching and directly interconnecting trenches in different shapes. For example, in the fabrication of a multi-trench structure with a deep trench and a trench array communicating with each other, according to the traditional method, a deep trench is firstly etched as shown in Fig. 1a, then etching is continued directly on one side of the deep trench to form a trench array, and the deep trench and the trench array are enabled to communicate with each other to form the required multi-trench structure, as shown in Fig. 1b. However, since the multi-trench structure is composed of complex trenches and cavities, trench sidewalls or other films surrounding the trenches obtained by the traditional fabrication process very much incline to break or fall off, making it difficult to carry out the subsequent device fabrication process. This is particularly true in the case of a trench array with the bottom portions communicating with each other to form a cavity and the top portions being separated from each other, where the construction of this trench array is harder to achieve stable in itself, and thus phenomena of film breakage or falling off are even easier to occur in a multi-trench structure containing such a trench array. Therefore, it has become a key challenge in device fabrication to adjust the fabrication process to solve this problem.

For the purpose of solving this problem, the present invention makes improvement on the traditional process, and provides a new process for fabricating a multi-trench structure, which may enhance stability of the resulting trench structure and effectively improve the product's yield. The process will be described in detail below in combination with the accompanying drawings.

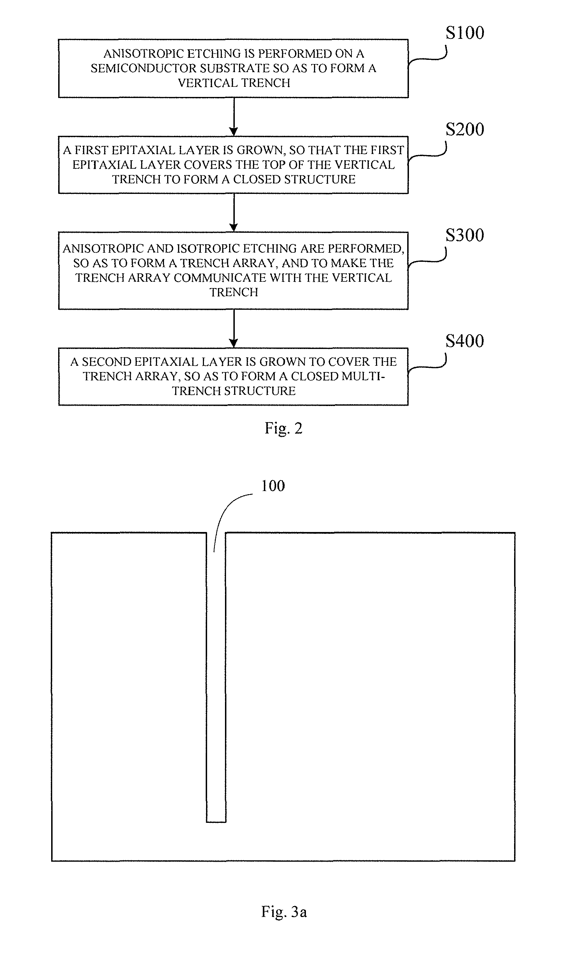

Fig. 2 illustrates a flow chart of a method for fabricating a multi-trench structure according to an embodiment of the present invention. Figs. 3a-3d illustrate a schematic cross section view of a structure obtained after completion of various steps according to this embodiment. By referring to Figs. 2 and 3a-3d, the method for fabricating a multi-trench structure comprises the following steps:

At Step S100, anisotropic etching is performed on a semiconductor substrate so as to form a vertical trench 100, as shown in Fig. 3a. Here, alternatively, the semiconductor substrate is a silicon substrate. Preferably, the anisotropic etching is implemented by a reactive ion etching process, which is a type of dry etching, and thereby facilitates forming a vertical trench 100 with a smaller diameter, good verticality, and a higher aspect ratio.

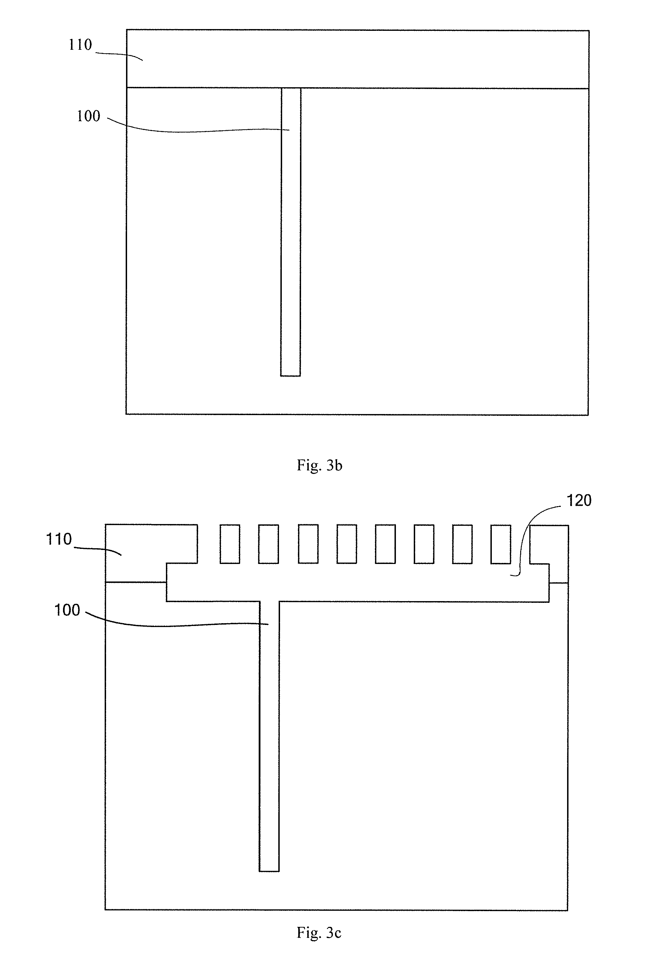

At Step S200, a first epitaxial layer 110 is grown on the semiconductor substrate in which the vertical trench 100 has been formed, so that the first epitaxial layer 110 covers the top of the vertical trench 100 to form a closed structure, as shown in Fig. 3b.

The inventor found out by research that according to the traditional etching technology, since etching is continuously performed on trenches of different structures, a trench array is formed by continued etching performed on the semiconductor substrate in which a vertical trench has already been etched. However, the substrate in which a deep trench has been etched may have certain surface defects, and the continued etching performed on the substrate material with defects are easy to cause more defects and expand the original detects. In addition, the substrate structure in which a deep trench has been etched is less stable, and the trench array per se has a more complex construction. After continued etching is performed on the structure with less stability and more defects and then a wet drying process is carried out, phenomena of film breakage or falling off are very easy to occur. Therefore, according to the present invention, a relatively stable closed structure can be obtained by the growth of the first epitaxial layer 110, and the regrown epitaxial material has a smooth surface and less defects. Continued etching of the trench array on the basis of this stable structure can ensure the stability of the subsequently etched structure.

Here the first epitaxial layer 110 is grown preferably by reduced pressure chemical vapor deposition, growth gas is preferably SiH₂Cl₂, SiHCl₃ or SiCl₄, and a growth temperature is preferably 1100°C∼1150°C. In order to form a stable closed structure, the first epitaxial layer 110 is preferably grown to 4∼10 µm in thickness, such as 6 µm. By controlling the rate and time of epitaxial growth, the thickness of the epitaxial layer may be accurately manipulated.

At Step S300, anisotropic and isotropic etching are performed on the closed structure, so as to form a trench array 120, and to make the trench array 120 communicate with the vertical trench 110 as shown in Fig. 3c. To ensure that the trench array 120 and the vertical trench 110 communicated with each other, the etching depth of the trench array 120 has to be greater than the growth thickness of the first epitaxial layer 110. Here the trench array 120 comprises a number of trenches or vias, upper portions of a number of trenches or vias being separated from each other and lower portions thereof communicating with each other to form a cavity.

Preferably, anisotropic etching is firstly performed on the closed structure to form a number of vias or trenches; and then, isotropic etching is performed on a number of vias or trenches, so that lower portions of adjacent vias or trenches communicate with each other to form a cavity. A number of vias or trenches is arranged at a substantially equal interval according to the device design requirement. It should be noted that, the number, the shape (such as circular or square) and the specific arrangement of a number of vias or trenches are not limited, and those skilled in the art may choose on the basis of the shape and size of the area of the desired cavity, the etching conditions, etc.

Preferably, both the anisotropic etching and the isotropic etching are implemented by reactive ion etching. At this step, poor conformality (which is avoided as much as possible during an etching process in general) of the anisotropic etching is exploited to practically etch away the silicon between bottom portions of adjacent vias or trenches under the performance of the isotropic etching, so as to enable them to communicate with each other to form a cavity. Specifically, in this embodiment, when continued etching of the bottom portions is performed, process conditions of the reactive ion etching, preferably, are controlled to turn it from anisotropic etching to isotropic etching (wherein chemical reactive etching is dominant, while the rate of physical etching is comparatively low). Therefore, the bottom portions of a number of vias or trenches may be horizontally etched at a higher rate until parts of the silicon substrate situated between the bottom portions of neighboring vias or trenches are etched away, so that various vias or trenches communicate with each other at the bottom portions thereof to form a cavity. The specific shape and size of the cavity is not limited, either.

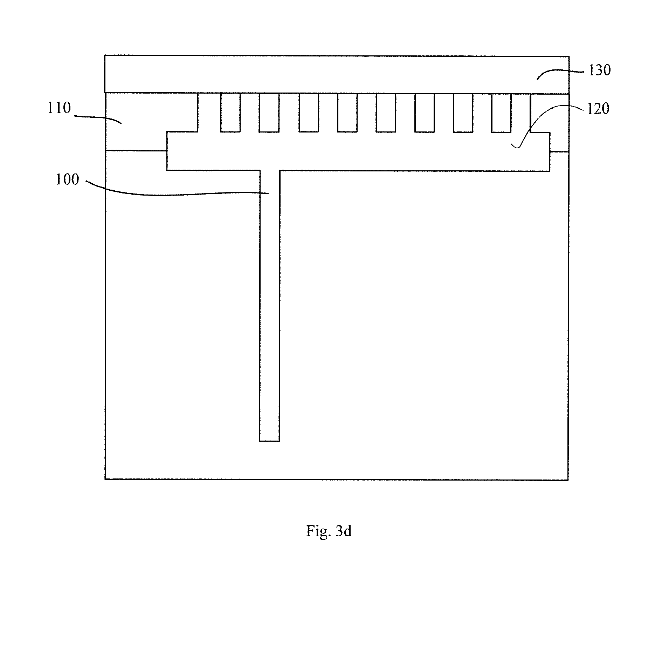

At Step S400, a second epitaxial layer 130 is grown to cover the trench array 120, so as to form a closed multi-trench structure, as shown in Fig. 3d, wherein the second epitaxial layer 130 is grown preferably by reduced pressure chemical vapor deposition, a growth gas is preferably SiH₂Cl₂, SiHCl₃ or SiCl₄, and a growth temperature is preferably 1100°C∼1150°C.

In this embodiment, essentially the first and the second epitaxial layers are only grown on a surface of the structure, that is, in the epitaxial growth, an epitaxial lay is not grown in the vertical trench 100 or the trench structure 120 essentially; therefore, the epitaxial surface of the epitaxial layer (namely, the upper surface of the epitaxial layer) is relatively flat, which is advantageous in performing a complex etching process again or further fabricating other devices in the epitaxial layer.

The abovementioned epitaxial growth requirement may be satisfied by controlling epitaxial growth conditions. In a preferred embodiment, SiH₂Cl₂, SiHCl₃ or SiCl₄ is selected as reaction gas for epitaxial growth, and a temperature for epitaxial growth is set at 1100°C∼1150°C (such as 1135°C). Therefore, the flatness of the epitaxial surface of the epitaxial layer formed by epitaxial growth may be within 1000 angstrom.

It should be noted that although the above embodiments take a silicon substrate as example to explain the method for forming a multi-trench structure therein, those skilled in the art, in light of the teachings and inspirations as indicated above, could apply the basic principle of the abovementioned method process to other semiconductor substrates, such as germanium substrate, polysilicon substrate, GaN semiconductor substrate, etc., to form a multi-trench structure.

Through experiment contrasts, compared with the traditional technology, the method for fabricating a multi-trench structure provided by the present invention enables the multi-trench structure to remain stable and solid in the fabricating process by growing epitaxial layers without phenomena of film breakage or falling off after undergoing high-speed drying in the subsequent wet cleaning process, significantly increasing the product yield.

The above discussions of the disclosed embodiments would enable those skilled in the art to implement or use the present invention. Various modifications to these embodiments could be apparent to those skilled in the art, and the general principle defined herein may be implemented in other embodiments without departing from the sprit or scope of the present invention. Therefore, the present invention shall not be limited to those embodiments illustrated herein, but instead, it shall be extended to the widest scope consistent with the principle and novel features disclosed herein.

## Claims

1. A method for fabricating a multi-trench structure, comprising the following steps:
Step 1: performing anisotropic etching on a semiconductor substrate so as to form a vertical trench;
Step 2: growing a first epitaxial layer on the semiconductor substrate in which the vertical trench has been formed, so that the first epitaxial layer covers the top of the vertical trench to form a closed structure;
Step 3: performing anisotropic and isotropic etching on the closed structure, so as to form a trench array, and to make the trench array communicate with the vertical trench; the trench array comprising a plurality of trenches or vias, upper portions of the plurality of trenches or vias being separated from each other and lower portions thereof communicating with each other to form a cavity; and
Step 4: growing a second epitaxial layer to cover the trench array, so as to form a closed multi-trench structure.

2. The method for fabricating a multi-trench structure according to claim 1, wherein the semiconductor substrate is a silicon substrate.

3. The method for fabricating a multi-trench structure according to claim 1, wherein the first epitaxial layer is grown to 4∼10 µm in thickness.

4. The method for fabricating a multi-trench structure according to claim 1, wherein the first and second epitaxial layers are grown by low pressure chemical vapor deposition.

5. The method for fabricating a multi-trench structure according to claim 1, wherein the first and second epitaxial layers are grown at a set temperature of 1100°C∼1150°C.

6. The method for fabricating a multi-trench structure according to claim 1, wherein growth gas for growing the first and second epitaxial layers is SiH₂Cl₂, SiHCl₃ or SiCl₄.

7. The method for fabricating a multi-trench structure according to claim 1, wherein in Step 3, anisotropic etching is firstly performed on the closed structure to form a plurality of vias or trenches; and then, isotropic etching is performed on the plurality of vias or trenches, so that lower portions of adjacent vias or trenches to communicate with each other to form a cavity.

8. The method for fabricating a multi-trench structure according to claim 1, wherein the plurality of vias or trenches is arranged at a substantially equal interval.

9. The method for fabricating a multi-trench structure according to claim 1, wherein both the anisotropic etching and the isotropic etching are implemented by reactive ion etching.
